# DEMANDE DE BREVET EUROPEEN

(11) **EP 2 447 790 A1**
(43) Date de publication de la demande: **02.05.2012**
(21) Numéro de dépôt: 10189101.8
(22) Date de dépôt: 27.10.2010
(51) Int. Cl.: G04B 39/00, G04B 39/02, G04G 21/08

(54) **Glace servant à fermer par le haut la boîte d'un objet portable**

(71) Demandeur: The Swatch Group Research and Development Ltd., 2074 Marin (CH)
(72) Inventeur: Poli, Gian-Carlo, 2206, Les Geneveys-sur-Coffrane (CH)
(74) Mandataire: Giraud, Eric

(57) **Abrégé**

Glace servant à fermer par le haut une boîte d'un objet portable, cette glace (1) étant réalisée en un matériau plastique transparent et étant destinée à être fixée sur la boîte de l'objet portable par soudage aux ultrasons, cette glace (1) présentant une surface supérieure (2) et une surface inférieure (4), cette glace (1) étant caractérisée en ce qu'elle présente un rebord périphérique (8) qui s'étend le long d'au moins une partie du périmètre de la glace (1), ce rebord périphérique (8) ayant une épaisseur (e) inférieure à la section (s) de la glace (1) dans la zone où le rebord périphérique (8) se raccorde à la glace (1), ce rebord périphérique (8) procurant au moins une surface de soudage par ultrasons de la glace (1) sur la boîte de l'objet portable.

## Description

La présente invention concerne une glace servant à fermer par le haut une boîte d'un objet portable. Plus précisément, la présente invention concerne une glace réalisée en un matériau plastique transparent destinée à être soudée par ultrasons sur la boîte de l'objet portable.

Au sens de la présente invention, on entend par objet portable un objet de petites dimensions pouvant par exemple être porté au poignet d'un utilisateur comme une montre-bracelet. Il peut également s'agir d'un téléphone portable ou bien encore d'un ordinateur portable. De manière succincte, de tels objets comprennent une boîte dans laquelle sont logés des composants électroniques ou électromécaniques et qui est fermée à sa base par un fond et à son sommet par une glace ou par un écran.

Considérons le cas particulier d'une montre-bracelet à touches tactiles capacitives. Ces touches tactiles sont créées en déposant sur la face inférieure de la glace de la montre (c'est-à-dire la face de la glace tournée du côté du cadran de la montre) des électrodes réalisées en un matériau conducteur transparent. En approchant un doigt de la surface de la glace de la montre, l'utilisateur engendre une variation de capacité entre son doigt et l'électrode en regard. Cette variation de capacité est détectée par un circuit de commande de la montre et est interprétée par ce circuit de commande comme une introduction d'une instruction. L'opération correspondant à l'instruction introduite est ensuite exécutée par le circuit de commande de la montre.

Les électrodes de détection de variation de la capacité sont réalisées en un matériau conducteur transparent tel que de l'oxyde d'étain-indium mieux connu sous sa dénomination anglo-saxonne Indium-Tin Oxyde ou ITO. Ces électrodes sont structurées sur la face inférieure de la glace et s'étendent jusque vers le bord périphérique de cette glace afin de permettre leur connexion avec l'électronique de commande située dans la boîte de montre. La glace est réalisée en un matériau plastique transparent et est soudée sur la boîte de la montre, également en plastique, par ultrasons. Plus précisément, on dispose au niveau du bord périphérique de la glace un élément appelé guide d'onde. Ce guide d'onde permet de concentrer les ondes ultrasonores et de provoquer un échauffement localisé qui provoque le soudage par fusion de la glace et de la boîte de la montre.

Or, les électrodes s'étendent jusqu'à proximité du bord périphérique de la glace et sont donc soumises, lors du soudage par ultrasons, à des contraintes mécaniques et thermiques sévères. Comme les électrodes sont rigides, elles supportent mal ces contraintes qui peuvent les endommager, voire les désolidariser de leur substrat.

En outre, quand bien même on tenterait de réaliser le soudage d'une telle glace au moyen d'ultrasons, la présence des pistes conductrices transparentes rendrait cette opération peu commode à réaliser, car la matière dans laquelle sont réalisées les pistes conductrices transparentes est beaucoup plus dure que le matériau plastique dans lequel est réalisée la glace. Par conséquent, la solution habituellement retenue pour fixer une glace en matière plastique sur une carrure de montre est le collage au moyen d'un adhésif. Les inconvénients d'une telle solution sont connus: avec le temps, l'adhésif vieillit, ce qui entraîne des problèmes d'étanchéité, voire des problèmes de tenue mécanique.

La présente invention a pour but de pallier cet inconvénient ainsi que d'autres encore en procurant une glace réalisée en un matériau plastique transparent munie de surfaces de soudage par ultrasons éloignées de la surface inférieure de la glace.

A cet effet, la présente invention concerne une glace servant à fermer par le haut une boîte d'un objet portable, cette glace étant réalisée en un matériau plastique transparent et étant destinée à être fixée sur la boîte de l'objet portable par soudage aux ultrasons, cette glace présentant une surface supérieure et une surface inférieure, cette glace étant caractérisée en ce qu'elle présente un rebord périphérique qui s'étend le long d'au moins une partie du périmètre de la glace, ce rebord périphérique ayant une épaisseur inférieure à la section de la glace dans la zone où le rebord périphérique se raccorde à la glace, ce rebord périphérique procurant au moins une surface de soudage par ultrasons de la glace sur la boîte de la montre.

Grâce à ces caractéristiques, la présente invention procure une glace pour la fermeture d'une boîte d'un objet portable qui présente un rebord périphérique permettant de déporter l'emplacement du soudage par ultrasons sur une zone éloignée du plan dans lequel s'étend la surface inférieure de la glace. Ceci permet d'éviter d'endommager toute structure éventuellement reportée sur la face inférieure de la glace. En outre, en procurant un rebord périphérique dont la section est moindre que celle de la glace dans la zone où le rebord périphérique se raccorde à la glace, on rend le soudage par ultrasons plus aisé en réduisant la quantité d'énergie ultrasonore nécessaire. Ceci est également favorable à la préservation des structures reportées sur la face inférieure de la glace.

Selon une caractéristique complémentaire de l'invention, le rebord périphérique comprend une surface supérieure et une surface inférieure, la surface inférieure du rebord périphérique étant plus proche de la surface supérieure de la glace que de la surface inférieure de cette glace. De la sorte, la zone de soudage est éloignée autant que possible de la surface inférieure de la glace sur laquelle peuvent être structurés des éléments sensibles à la chaleur et aux contraintes mécaniques que la chaleur induit, ce qui permet de préserver au mieux ces éléments.

La présente invention présente un intérêt tout particulier lorsque la face inférieure de la glace est revêtue d'une ou de plusieurs pistes conductrices réalisées en un matériau conducteur transparent tel que de l'ITO. En effet, ces pistes conductrices ne sont pas ductiles et ont donc tendance à se décoller par effet de délaminage lors de l'élévation de température induite par le soudage par ultrasons. Grâce à la présence du rebord périphérique, le soudage par ultrasons se fait sur des surfaces dépourvues de couche conductrice transparente et suffisamment éloignées de ces couches conductrices transparentes pour que les contraintes mécaniques engendrées par le soudage par ultrasons soient sans effet sur l'adhésion de ces couches sur la face inférieure de la glace.

D'autres caractéristiques et avantages de la présente invention ressortiront plus clairement de la description détaillée qui suit d'un mode de réalisation de la glace selon l'invention, cet exemple étant donné à titre purement illustratif et non limitatif seulement en liaison avec le dessin annexé dans lequel:

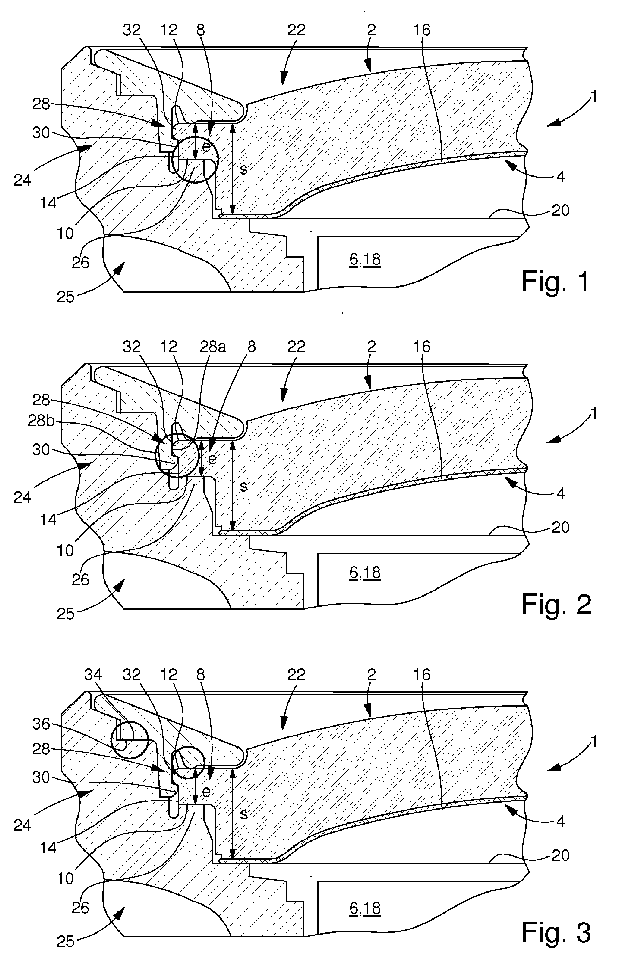

- la figure 1 est une vue partielle en coupe d'une glace de montre dans la région où cette glace se raccorde à la carrure et à la lunette de la montre, la glace étant munie d'un rebord périphérique de section sensiblement carrée conforme à la présente invention, la glace étant soudée par ultrasons sur la carrure de la montre via une première surface inférieure de soudage procurée par le rebord périphérique;
- la figure 2 est une vue analogue à celle de la figure 1, le rebord périphérique procurant une deuxième surface périphérique de soudage sensiblement perpendiculaire à la première surface de soudage par laquelle la glace est soudée par ultrasons sur la lunette, la lunette étant d'autre part soudée sur la carrure pour garantir l'étanchéité de la montre;
- la figure 3 est une vue analogue à celle de la figure 1, le rebord périphérique procurant une troisième surface supérieure de soudage s'étendant sensiblement parallèlement à la première surface inférieure de soudage, la glace étant soudée par ultrasons sur la lunette via cette troisième surface, la lunette étant d'autre part soudée par ultrasons sur la carrure pour garantir l'étanchéité de la montre, et

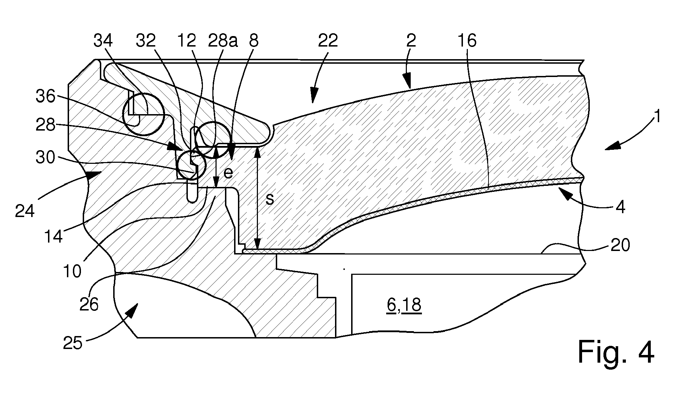

- la figure 4 est une vue analogue à celle de la figure 3, la glace étant simultanément soudée par ultrasons sur la lunette via la deuxième et la troisième surfaces de soudage, la lunette étant d'autre part soudée sur la carrure.

La présente invention procède de l'idée générale inventive qui consiste à munir une glace réalisée en un matériau plastique transparent et fermant par exemple une boîte de montre d'une collerette périphérique dont la section est inférieure à la section de la glace dans la zone où la collerette périphérique se raccorde à la glace. Cette collerette procure ainsi au moins une zone pour le soudage de la glace par ultrasons qui, du fait de son épaisseur réduite, nécessite un apport moindre en énergie ultrasonore et permet donc de réduire les risques d'endommager la glace lors du soudage. En outre, cette collerette permet d'éloigner l'emplacement du soudage par rapport à la surface inférieure de la glace, ce qui permet également de protéger la glace lors du soudage. Ces caractéristiques s'avèrent particulièrement avantageuses dans le cas où des éléments sont structurés sur la surface inférieure de la glace. Il peut s'agir notamment de pistes conductrices réalisées en un matériau conducteur transparent tel que de l'ITO et formant, par exemple, des touches tactiles capacitives pour l'introduction de données dans un circuit de commande de la montre ou bien encore une antenne. En effet, l'ITO est dur et donc cassant et supporte par conséquent très mal les augmentations de température et les contraintes mécaniques induites par l'échauffement localisé lors du soudage par ultrasons. De plus, l'ITO empêche le soudage par ultrasons des surfaces qu'il recouvre. Par conséquent, en éloignant l'emplacement du soudage par rapport aux pistes conductrices en ITO, on améliore grandement la qualité du soudage de même qu'on évite tout risque d'endommager les pistes conductrices en ITO. La présente invention propose ainsi une alternative au collage des glaces au moyen d'un adhésif dont les défauts sont bien connus: vieillissement de l'adhésif dans le temps avec risques de défauts d'étanchéité et mauvaise tenue mécanique.

La présente invention va être décrite en liaison avec une glace servant à fermer par le haut une boîte de montre. Il va de soi que la présente invention n'est pas limitée à ce mode de réalisation et qu'elle peut s'appliquer à d'autres objets portables tels qu'un téléphone portable ou bien encore l'écran d'un ordinateur. Dans de tels cas, la glace peut être un élément destiné à la protection d'une cellule d'affichage sous-jacente ou bien être l'un des substrats proprement dit d'une cellule d'affichage.

On se réfère maintenant à la figure 1 qui est une vue partielle en coupe d'une glace de montre selon l'invention. Désignée dans son ensemble par la référence numérique générale 1, cette glace de montre comprend une surface supérieure 2 tournée du côté de l'utilisateur et une surface inférieure 4 tournée du côté du mouvement 6 de la montre. On constate à l'examen du dessin que les surfaces supérieure 2 et inférieure 4 sont courbes et s'étendent à distance sensiblement constante l'une de l'autre. Bien entendu, selon un mode de réalisation non représenté, les surfaces supérieure 2 et inférieure 4 de la glace 1 pourraient être planes ou s'étendre à distance variable l'une de l'autre. La glace 1 est réalisée en un matériau plastique transparent pouvant être soudé par soudage par ultrasons.

Conformément à l'invention, la glace 1 présente un rebord périphérique 8 qui s'étend le long d'au moins une partie du périmètre de la glace 1. Dans le cas d'une glace de montre, on préférera que ce rebord périphérique s'étende sur tout le pourtour de la glace. Comme on peut l'observer à l'examen de la figure 1, le rebord périphérique 8 possède une épaisseur e inférieure à la section s de la glace 1 dans la zone où le rebord périphérique 8 se raccorde à la glace 1.

Dans l'exemple représenté à la figure 1, le rebord périphérique 8 présente une section sensiblement carrée et procure ainsi une première surface de soudage inférieure 10 et une deuxième surface de soudage supérieure 12 qui s'étendent parallèlement et à distance l'une de l'autre et qui sont reliées entre elles par une troisième surface de soudage 14 qui s'étend sensiblement perpendiculairement aux première et deuxième surfaces de soudage inférieure 10 et supérieure 12.

On a choisi de représenter le rebord périphérique 8 sous la forme d'une collerette de section carrée. Bien entendu, cet exemple est donné à titre purement illustratif seulement et le rebord périphérique peut présenter une section différente telle que rectangulaire, triangulaire, circulaire ou autre.

La surface de soudage inférieure 10 du rebord périphérique 8 est plus proche de la surface supérieure 2 de la glace 1 que de la surface inférieure 4 de cette glace 1. Comme cela sera décrit plus en détail ci-après, un tel agencement est particulièrement avantageux dans le cas où des pistes conductrices ou électrodes 16 réalisées en un matériau conducteur transparent tel que de l'oxyde d'étain-indium ou ITO sont structurées sur la face inférieure 4 de la glace 1. De telles électrodes 16 trouvent leur application dans la réalisation de touches tactiles permettant l'introduction de données dans un circuit de commande 18 de la montre par variation de la capacité entre un doigt de l'utilisateur qui effleure la surface supérieure 2 de la glace 1 et une électrode 16 considérée.

Le montage est complété par un cercle d'emboîtage 20 dans lequel est notamment logé le circuit de commande 18 de la montre. Une lunette 22 vient d'autre part en appui sur la surface supérieure 2 de la glace 1, l'ensemble formé par la glace 1 et la lunette 22 étant monté sur une carrure 24 pour former la boîte 25 de la montre.

Dans l'exemple de la figure 1, la glace 1 est soudée sur la carrure 24 de la montre via la première surface de soudage inférieure 10 qui vient en appui sur un épaulement 26 correspondant de la carrure 24. La zone de soudage est matérialisée par un cercle sur la figure 1. Cette première surface de soudage inférieure 10 s'étend parallèlement à et à distance des électrodes 16 structurées sur la face inférieure de la glace 1. Cette disposition rend le soudage par ultrasons d'une telle glace 1 possible. En effet, jusqu'à présent, de telles glaces revêtues sur leur face inférieure de pistes conductrices en ITO ou autre matériau transparent conducteur ne pouvaient qu'être collées au moyen d'un adhésif car les pistes conductrices en ITO rendaient presque impossible le soudage de la glace par ultrasons. L'ITO est un matériau dur qui gêne la fusion par soudage par ultrasons de la couche de matériau plastique sur laquelle ce matériau est déposé. En outre, l'ITO, parce qu'il est dur, est cassant et supporte donc très mal les élévations de température et les contraintes mécaniques induites par le soudage par ultrasons. Ainsi, en éloignant des pistes conductrices en ITO la zone où s'effectue le soudage par ultrasons, on évite tout risque d'endommager ces pistes conductrices. Quant à la lunette 22, elle est simplement encliquetée sur la glace 1 via une bague 28 qui présente à sa base un renflement 30 qui vient en prise sous une augmentation locale de diamètre 32 correspondante de la glace 1. Dans ce cas, la lunette 22 a une fonction purement décorative et ne contribue pas à l'étanchéité de la montre qui est garantie par le soudage entre la glace 1 et la carrure 24.

A la figure 2, la glace 1 est soudée par ultrasons sur la lunette 22 par l'intermédiaire de la troisième surface de soudage 14 qui s'étend sensiblement perpendiculairement aux première et deuxième surfaces de soudage inférieure 10 et supérieure 12, c'est-à-dire perpendiculairement au plan dans lequel s'étend le cercle d'emboîtage 20. La zone de soudage est matérialisée par un cercle sur la figure 2. On voit que la glace 1 est soudée sur la lunette 22 au niveau de la face intérieure 28a de la bague 28, tandis que la lunette 22 est soudée sur la carrure 24 au niveau de la face extérieure 28b de la bague 28 pour garantir l'étanchéité de la montre.

A la figure 3, la glace 1 est soudée sur la lunette 22 par l'intermédiaire de la deuxième surface de soudage supérieure 12 qui s'étend parallèlement à et au-dessus de la première surface de soudage inférieure 10. Les zones de soudage sont matérialisées par des cercles sur la figure 3. Pour garantir l'étanchéité de la montre, la lunette 22 est soudée sur la carrure 24 par un rebord annulaire 34 en appui contre un épaulement 36.

Selon une variante de réalisation de l'invention illustrée à la figure 4, il est possible de souder la glace 1 sur la lunette 22 par l'intermédiaire simultanée des deuxième et troisième surfaces de soudage 12 et 14. Les zones de soudage sont matérialisées par des cercles sur la figure 4. Ainsi, on voit que la glace 1 est soudée sur la lunette 22 d'une part au niveau de la face intérieure 28a de la bague 28, et d'autre part au niveau de la deuxième surface de soudage supérieure 12 qui s'étend parallèlement à et au-dessus de la première surface de soudage inférieure 10. Pour des raisons d'étanchéité, la lunette 22 est soudée sur la carrure 24 au niveau de son rebord annulaire 34.

On comprendra qu'il est également envisageable de souder la glace 1 d'une part sur la carrure 24 par l'intermédiaire de la première surface de soudage inférieure 10 comme illustré à la figure 1, et d'autre part sur la lunette 22 par l'intermédiaire de la deuxième ou troisième surface de soudage 12 ou 14.

## Revendications

1. Glace servant à fermer par le haut une boîte d'un objet portable, cette glace (1) étant réalisée en un matériau plastique transparent et étant destinée à être fixée sur la boîte de l'objet portable par soudage aux ultrasons, cette glace (1) présentant une surface supérieure (2) et une surface inférieure (4), cette glace (1) étant **caractérisée en ce qu'**elle présente un rebord périphérique (8) qui s'étend le long d'au moins une partie du périmètre de la glace (1), ce rebord périphérique (8) procurant au moins une surface de soudage par ultrasons de la glace (1) sur la boîte de l'objet portable.

2. Glace selon la revendication 1, **caractérisée en ce que** ce le rebord périphérique (8) possède une épaisseur (e) inférieure à la section (s) de la glace (1) dans la zone où le rebord périphérique (8) se raccorde à la glace (1).

3. Glace selon l'une quelconque des revendications 1 ou 2, **caractérisée en ce que** la section du rebord périphérique (8) est rectangulaire ou carrée.

4. Glace selon l'une quelconque des revendications 1 à 3, **caractérisée en ce que** la surface inférieure (4) de la glace (1) supporte une ou des pistes conductrices (16) réalisées en un matériau conducteur transparent.

5. Glace selon l'une quelconque des revendications 1 à 4, **caractérisée en ce que** le rebord périphérique (8) comprend une surface supérieure (12) et une surface inférieure (10), la surface inférieure (10) du rebord périphérique (8) étant plus proche de la surface supérieure (2) de la glace (1) que de la surface inférieure (4) de cette glace (1), la surface supérieure (12) et la surface inférieure (10) du rebord périphérique (8) étant reliées entre elles par une troisième surface de soudage (14).

6. Glace selon la revendication 5 servant à fermer la boîte (25) d'une montre-bracelet, cette boîte (25) comprenant une lunette (22) qui vient en appui sur la surface supérieure (2) de la glace (1), l'ensemble formé par la glace (1) et la lunette (22) étant monté sur une carrure (24) pour former la boîte (25) de la montre, **caractérisée en ce que** la glace (1) est soudée par ultrasons par au moins une des surfaces de soudage (10, 12, 14) procurées par le rebord périphérique (8) sur la carrure (24) ou la lunette (22).
